**Europäisches Patentamt**

**European Patent Office**

**Office européen des brevets**

(19)

(11) Veröffentlichungsnummer: **0 044 803**
**A2**

(12) # EUROPÄISCHE PATENTANMELDUNG

(21) Anmeldenummer: **81730058.5**

(22) Anmeldetag: **29.06.81**

(51) Int. Cl.³: **H 05 K 3/34**
**B 23 K 35/22**

(30) Priorität: **17.07.80 DE 8019411 U**

(43) Veröffentlichungstag der Anmeldung:
**27.01.82 Patentblatt 82/4**

(84) Benannte Vertragsstaaten:
**CH DE GB LI SE**

(71) Anmelder: **SIEMENS AKTIENGESELLSCHAFT Berlin und München**
**Postfach 22 02 61**
**D-8000 München 22(DE)**

(72) Erfinder: **Süsskind, Egon**
**Pfalzburger Strasse 59**
**D-1000 Berlin 31(DE)**

(54) **Verfahren zum Herstellen einer mit elektrischen Bauelementen bestückten Leiterplatte.**

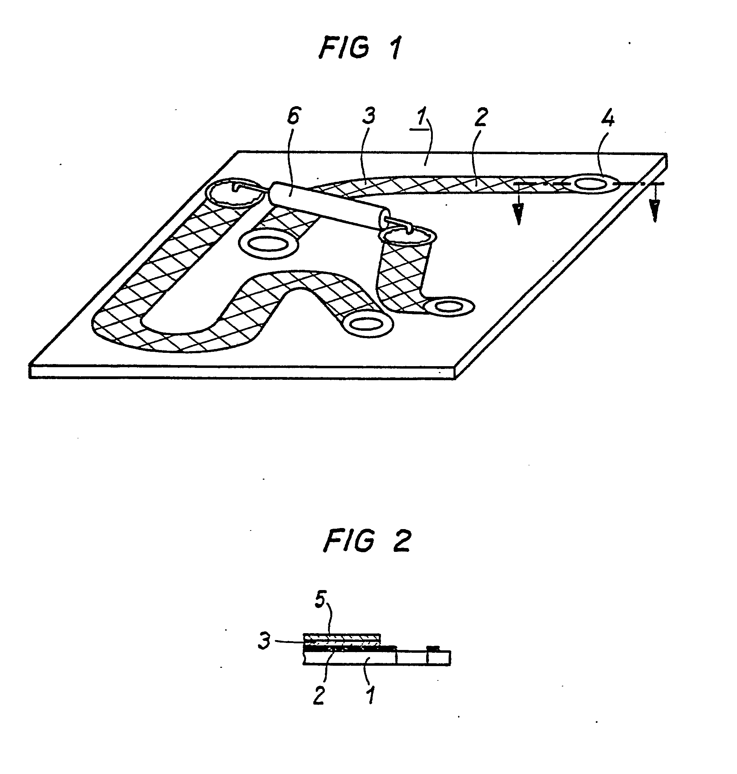

(57) Die Erfindung bezieht sich auf ein Verfahren zum Herstellen einer mit elektrischen Bauelementen bestückten Leiterplatte, bei dem die Leiterbahnen mit einem Lötstoplack bedruckt werden, die Bauelemente einsetzen und verlöten und anschließend die von den Bauelementen freie Seite mit einer Isolierlackschicht überzogen wird. Um das Verfahren vergleichsweise einfach ausführen zu können und eine hohe Isolatiosnfestigkeit zwischen den Leiterbahnen zu erreichen, erfolgt anstelle des Überziehens mit der Isolierlackschicht ein weiteres Bedrucken der Leiterbahnen (2) mit dem Lötstoplack. Das Verfahren ist zum Herstellen beliebiger Leiterplatten geeignet (Fig. 1).

FIG 1

EP 0 044 803 A2

SIEMENS AKTIENGESELLSCHAFT    Unser Zeichen
Berlin und München           VPA 80 P 3748 E

Verfahren zum Herstellen einer mit elektrischen Bauelementen bestückten Leiterplatte

Die Erfindung bezieht sich auf ein Verfahren zum Herstellen einer mit elektrischen Bauelementen bestückten Leiterplatte, bei dem die Leiterbahnen mit einem Lötstoplack unter Freilassung der Lötaugen bedruckt werden, die Bauelemente eingesetzt und verlötet und anschließend die von den Bauelementen freie Seite der Leiterplatte mit einer Schicht aus einem Isolierlack überzogen wird.

In im Handel befindlichen Geräten angeordnete Leiterplatten sind auf ihren Leiterbahnen mit einem Lötstoplack versehen, der unter Freilassung der Lötaugen aufgedruckt ist. Durch den Lötstoplack wird erreicht, daß nur im Bereich der Lötaugen von den Leiterbahnen beim Einlöten der Bauelemente Zinn aufgenommen wird, wodurch sich eine Einsparung an Zinn ergibt. Lötstoplack wird nicht nur bei einseitig, sondern auch bei zweiseitig mit Leiterbahnen versehenen Leiterplatten aufgedruckt. Nach dem Aufbringen des Lötstoplackes auf die Leiterbahnen werden die Bauelemente in entsprechend vorbereitete Löcher der Leiterplatten eingesetzt und im Bereich der Lötaugen mit den Leiterbahnen verlötet. Die fertig bestückte Leiterplatte wird danach auf ihrer von den Bauelementen freien Seite mit einer Schicht aus einem Isolierlack in einem zusätzlichen Arbeitsgang versehen, die einerseits einen Schutz gegen Staub und Feuchtigkeit bildet und andererseits eine höhere Isolationsfestigkeit bewirkt.

Die bekannten Leiterplatten sind bezüglich ihrer Herstellung insofern aufwendig, als in einem zusätzlichen Arbeitsgang auf der von den Bauelementen freie Seite

Kr 3 Sby / 16.07.1989

eine Schicht aus einem Isolierlack aufgebracht wird;
hinzu kommt, daß eine derartige Beschichtung nur auf
der von den Bauelementen freien Seite der Leiterplatten möglich ist, weil bei einem Lackauftrag auf der anderen
Seite der Leiterplatte die Bauelemente unbeabsichtigterweise ebenfalls mit dem Isolierlack überzogen würden,
was beispielsweise im Falle von dort angebrachten Steckern,
Relais oder Schaltern die Funktionsweise erheblich beeinträchtigen würde. Ein Auftragen der Schicht aus dem
Isolierlack vor dem Bestücken der Leiterplatten mit
den Bauelementen ist nicht möglich, weil sich dann die
Löcher zur Aufnahme der Anschlußenden der Bauelemente
in der Leiterplatte zusetzen würden.

Der Erfindung liegt daher die Aufgabe zugrunde, ein
Verfahren zum Herstellen einer mit elektrischen Bauelementen bestückten Leiterplatte vorzuschlagen, das
sich vergleichsweise einfach durchführen läßt und eine
hohe Isolationsfestigkeit zwischen Leiterbahnen auf
beiden Seiten einer Leiterplatte ermöglicht.

Zur Lösung dieser Aufgabe entfällt bei einem Verfahren
der eingangs angegebenen Art erfindungsgemäß das Überziehen der freien Seite der Leiterplatte mit dem Isolierlack, und es wird nach dem Bedrucken mit dem Lötstoplack ein weiterer Druck mit dem Lötstoplack auf den
Leiterbahnen unter Freilassung der Lötaugen vorgenommen.

Ein wesentlicher Vorteil des erfindungsgemäßen Verfahrens besteht darin, daß allein durch einen weiteren
Druck mit dem Lötstoplack eine derartige Isolationsfestigkeit zwischen den Leiterbahnen auf der Leiterplatte erzielbar ist, wie dies sonst nur auf der von
den Bauelementen freien Seite der Leiterplatte durch
das Aufbringen einer Schicht aus einem Isolierlack möglich war. Dies bedeutet, daß nach der gültigen VDE-
Richtlinie 0435 Kriechstrecken nach der Isolationsgruppe
A und nicht - wie bisher - nach der Isolationsgruppe
B bemessen werden können.Bei der Durchführung des erfindungsgemäßen Verfahrens ist also neben einem Lötstoplack ein zusätzlicher Isolierlack nicht mehr erforderlich. Es sind auch keine zusätzlichen Einrichtungen
mehr notwendig, um einen Isolierlack aufzutragen, weil
durch ein und dieselbe Einrichtung zum Drucken des Lötstoplackes eine derartige Schicht auf den Leiterbahnen
der Leiterplatten erzeugt wird, daß eine ausreichende
Isolationsfestigkeit gegeben ist. Ein besonderer Vorteil des erfindungsgemäßen Verfahrens besteht darin,
daß Leiterplatten mit Leiterbahnen auf beiden Seiten
eine ausreichende Isolationsfestigkeit erhalten können,
weil das erneute Bedrucken mit dem Lötstoplack vor dem
Bestücken der Leiterplatten erfolgt. Das erfindungsgemäße Verfahren läßt sich somit nicht nur mit weniger
Aufwand herstellen, sondern ermöglicht auch die Herstellung von Leiterplatten mit besseren isolationstechnischen Eigenschaften.

Der Erfindung liegt nämlich die Erkenntnis zugrunde,
daß durch ein zusätzliches Bedrucken der Leiterbahnen
mit einem Lötstoplack eine Isolationsschicht auf den
Leiterbahnen gebildet ist, die mit der unter Verwendung
eines Isolierlackes gewonnenen Schicht in ihren Eigenschaften vergleichbar ist. Da die auf Leiterplatten
verwendeten Bauelemente und die Anordnung der Leiterbahnen
im Bereich der Lötaugen von vornherein so gewählt sind,
daß sie verhältnismäßig hohen Isolationsanforderungen
genügen, kommt es auf die Isolationsfestigkeit der Leiterbahnen untereinander besonders an, wenn die Leiterbahnen in vorteilhafter Weise dicht nebeneinander verlaufen sollen. Dies ist bisher nur auf der von Bauelementen
freien Seite durch einen Auftrag einer Schicht aus einem
Isolierlack erreichbar gewesen. Gemäß der Erfindung lassen sich die Leiterbahnen auf beiden Seiten einer
Leiterplatte isolationsfest machen und können daher
auf beiden Seiten dicht nebeneinander verlaufen.

Es hat sich erwiesen, daß Lötstoplacke unterschiedlicher
Art im Rahmen des erfindungsgemäßen Verfahrens Verwendung finden können, z. B. ofentrocknende Lötstoplacke
oder UV-trocknende Lötstoplacke. Als besonders vorteilhaft hat sich aber die Verwendung von zwei Komponenten-Lötstoplacken erwiesen, weil diese eine sehr geringe
Porösität aufweisen.

Eine nach dem erfindungsgemäßen Verfahren hergestellte
Leiterplatte mit Leiterbahnen auf beiden Seiten läßt
sich in vorteilhafter Weise so ausführen, daß auch über
Leiterbahnen sich erstreckende Bauelemente unmittelbar auf der Leiterplatte aufliegen. Dies ist dadurch
ermöglicht, daß auf den Leiterbahnen eine verhältnismäßig isolationsfeste Schicht aus dem Lötstoplack vorhanden ist. Dadurch wird die Bauhöhe der bestückten
Leiterplatte insgesamt vergleichsweise niedrig, so daß
ein Gerät mit mehreren nebeneinander angeordneten Leiterplatten vergleichsweise kompakt ausgeführt werden
kann.

Zur Erläuterung der Erfindung ist in
Fig. 1 eine Draufsicht auf ein Ausführungsbeispiel einer nach dem erfindungsgemäßen Verfahren hergestellten
Leiterplatte und in
Fig. 2 ein Schnitt durch einen Teil der Leiterplatte
nach Fig. 1 wiedergegeben.

Die in den Figuren 1 und 2 dargestellte Leiterplatte 1
ist in der Weise hergestellt, daß auf ihre Leiterbahnen 2, gegebenenfalls nach einer Oberflächenveredelung
der Leiterbahnen 2, eine Schicht 3 aus einem Lötstoplack aufgedruckt/ist. Dabei ist dafür gesorgt, daß die Lötaugen 4 vom Lötstoplack frei bleiben. Nach dem ersten Aufdruck mit dem Lötstoplack auf die Leiterbahnen 2 erfolgt ein weiterer Druck mit dem Lötstoplack, wodurch eine weitere Schicht 5 auf den Leiterbahnen entsteht. Oberhalb der Leiterbahnen ist somit der Lötstoplack in zwei Schichten 3 und 5 aufgedruckt.

Nachdem die Leiterplatte soweit hergestellt ist, wird sie mit Bauelementen 6 bestückt, von denen in der Fig. 1 beispielhaft nur ein einziges Bauelement dargestellt ist. Dieses Bauelement 6 kann unmittelbar auf der unter ihm hindurchführenden Leiterbahn 2 aufliegen, weil diese infolge des zweifachen Bedruckens mit dem Lötstoplack ausreichend isoliert ist.

Die Leiterplatte 2 kann auch auf ihrer in der Fig. 1 nicht erkennbaren Seite Leiterbahnen tragen, die dann ebenso wie die dargestellten Leiterbahnen 2 zweimal hintereinander mit dem Lötstoplack bedruckt sind.

Mit der Erfindung ist ein Verfahren geschaffen, mit dem sich mit elektrischen Bauelementen bestückte Leiterplatte mit relativ geringem Aufwand und in kompakter Bauweise bei hoher Isolationsfestigkeit herstellen lassen.

3 Patentansprüche
2 Figuren

Patentansprüche

1. Verfahren zum Herstellen einer mit elektrischen Bauelementen bestückten Leiterplatte, bei dem
   a) die Leiterbahnen mit einem Löststoplack unter Freilassung der Lötaugen bedruckt werden,
   b) die Bauelemente eingesetzt und verlötet und anschließend
   c) die von den Bauelementen freie Seite der Leiterplatte mit einer Schicht aus einem Isolierlack überzogen wird,

d a d u r c h   g e k e n n z e i c h n e t , daß
   d) das Überziehen der freien Seite der Leiterplatte (2) mit dem Isolierlack entfällt und daß
   e) nach dem Bedrucken mit dem Lötstoplack ein weiterer Druck mit dem Lötstoplack auf den Leiterbahnen (1) unter Freilassung der Lötaugen (4) vorgenommen wird.

2. Verfahren nach Anspruch 1, d a d u r c h   g e k e n n z e i c h n e t , daß ein Zweikomponenten-Lötstoplack verwendet wird.

3. Nach dem Verfahren nach Anspruch 1 oder 2 hergestellte Leiterplatte mit Leiterbahnen auf beiden Seiten, d a d u r c h   g e k e n n z e i c h n e t , daß auch über Leiterbahnen (1) sich erstreckende Bauelemente (6) unmittelbar auf der Leiterplatte (2) aufliegen.

0044803

## FIG 1

## FIG 2